# EUROPÄISCHE PATENTSCHRIFT

(11) **EP 2 057 299 B1**
(45) Veröffentlichungstag und Bekanntmachung des Hinweises auf die Patenterteilung: **10.08.2016**
(21) Anmeldenummer: 07801944.5
(22) Anmeldetag: 29.08.2007
(51) Int. Cl.: C23C 14/50

(54) **VORRICHTUNG ZUM WENDEN EINES GEGENSTANDS IN EINER VAKUUMBESCHICHTUNGSANLAGE, VERFAHREN ZUM WENDEN EINES GEGENSTANDS IN EINER VAKUUMBESCHICHTUNGSANLAGE SOWIE DEREN VERWENDUNG**
DEVICE FOR TURNING AN ARTICLE IN A VACUUM COATING INSTALLATION, METHOD OF TURNING AN ARTICLE IN A VACUUM COATING INSTALLATION AND USE THEREOF
DISPOSITIF ET PROCÉDÉ POUR RETOURNER UN OBJET DANS UNE INSTALLATION DE REVÊTEMENT SOUS VIDE, ET LEUR UTILISATION

(30) Priorität: 01.09.2006 DE 102006041137
(43) Veröffentlichungstag der Anmeldung: 13.05.2009
(73) Patentinhaber: Carl Zeiss Vision GmbH, 73430 Aalen (DE)
(72) Erfinder: MACIONCZYK, Frank, 73447 Oberkochen (DE)
(74) Vertreter: Carl Zeiss AG - Patentabteilung
(86) Internationale Anmeldenummer: PCT/EP2007/007522
(87) Internationale Veröffentlichungsnummer: WO 2008/025519

(56) Entgegenhaltungen:
- DE-C2- 3 921 672
- JP-A- 2003 313 653

## Beschreibung

Vorrichtung zum Wenden eines Gegenstands in einer Vakuumbeschichtungsanlage, Verfahren zum Wenden eines Gegenstands in einer Vakuumbeschichtungsanlage sowie deren Verwendung.

Die Erfindung betrifft eine Vorrichtung zum Wenden eines Gegenstands, insbesondere eines optischen Elements wie z.B. einer Linse oder eines nichtoptischen Elements wie z.B. eines Bohrers, vor oder während oder nach dessen Beschichtung in einer Vakuumbeschichtungsanlage nach dem Oberbegriff der Patentansprüche 1 und 2, ein Verfahren zum Wenden dieses Gegenstands in der Vakuumbeschichtungsanlage nach dem Oberbegriff der Patentansprüche 11 und 12 sowie deren Verwendung.

Unter Vakuumbeschichtungsanlage ist vorliegend eine Anlage zu verstehen, mit der unter Vakuum-, insbesondere Hochvakuum-Bedingungen Gegenstände beschichtet werden können. Hierzu gehören beispielsweise Kathodenzerstäubungsanlagen (Sputteranlagen), Bedampfungsanlagen oder chemischeGasphasenabscheidungsanlagen.

Unter einem optischen Element wird nachfolgend ein Gegenstand verstanden, welcher bestimmungsgemäß eine elektromagnetische Strahlung, wie z.B. sichtbares Licht, UV- oder IR-Strahlung absorbierende, transmittierende, reflektierende, brechende oder streuende Funktion aufweist. Insbesondere gehören hierzu Linsen, beispielsweise Brillenlinsen oder Kontaktlinsen. Weiter gehören hierzu Plan- und Rundoptiken, Prismen, sphärische oder asphärische Gläser, formgerandete Brillengläser, elliptische Gläser usw. Unter nichtoptischem Element wird nachfolgend ein Gebrauchsgegenstand anderer Art verstanden. Beispielhaft seien Werkzeuge oder Teile hiervon, wie z.B. Bohrer, oder Anlagenteile genannt.

Unter Wenden eines Gegenstands versteht man nachfolgend einen Vorgang, bei der sich die der Beschichtungsquelle zugewandte Oberfläche des Gegenstands ändert, im Gegensatz zu einem reinen Drehvorgang, bei dem die der Beschichtungsquelle zugewandte Oberfläche zwar ihre Lage in Bezug auf die Beschichtungsquelle ändert, dabei jedoch weiterhin der Beschichtungsquelle zugewandt bleibt. Nach einem Wenden um 180° ist die Rückseite des optischen Elements der Beschichtungsquelle zugewandt.

Die Erfindung wird nachfolgend am Beispiel einer Vorrichtung bzw. eines Verfahrens zum Wenden von ophthalmischen Kunststofflinsen beschrieben. Anstelle von ophthalmischen Kunststofflinsen könnten jedoch auch andere Gegenstände mit Hilfe der Vorrichtung bzw. mit Hilfe des Verfahrens gewendet werden.

Zur Entspiegelung von Brillengläsern werden dünne optische Schichten auf die Linsenoberflächen aufgetragen. Die Entspiegelungsschichten werden in Hochvakuumanlagen hergestellt. Dazu werden Herkömmlicherweise optisch wirksame Materialien im Hochvakuum aus einer Verdampferquelle heraus verdampft oder aus einer Sputterquelle heraus gesputtert und auf die Linsen abgeschieden. Die Linsen liegen in Halteringen oder befinden sich eingespannt in Spannringen, wobei jeweils eine Linsenseite der Verdampfer- oder Sputterquelle zugewandt ist. Die Ringe (Linsenhalter) werden üblicherweise in die dafür vorgesehenen Aussparungen von Trägerblechen eingelegt, die oberhalb der Verdampferquelle kalottenförmig angebracht sind und mittels einer Rotationsvorrichtung um die Symmetrieachse der Kalotte rotieren. Dabei bilden die Trägerbleche Segmente der Kalotte oder, im Fall nur eines Blechs, die Kalotte selbst. Bei der Verwendung von Spannringen liegen die Linsenhalter mit den eingespannten Linsen statisch im Trägerblech und werden nach Beschichtung der ersten Linsenseite, zusammen mit den Linsen, manuell gewendet, zur Beschichtung der zweiten Linsenseite. Diese Verfahrenstechnik zeichnet sich durch die Erzielung einer im Allgemeinen hohen Gutausbeute aus. Dazu trägt bei, dass die Linsen im Allgemeinen den Vakuumprozess durchlaufen, ohne einer Verschmutzung durch Abriebpartikeln von mechanisch bewegten Komponenten in der Vakuumkammer ausgesetzt zu sein.

Automatische Wendevorrichtungen für Linsenhalter erlauben ein Wenden der Linsen, ohne dass nach der Beschichtung der ersten Linsenseite die Vakuumkammer zum manuellen Wenden belüftet und anschließend erneut evakuiert werden muss. Dadurch kann sich, je nach Prozess und Anlagentyp, die zur Beschichtung beider Linsenseiten benötigte Gesamtprozesszeit erheblich verkürzen. Die üblichen Wendevorrichtungen sind aber für Beschichtungsprozesse im Vakuum mit mehreren Nachteilen behaftet, wie zusätzliche Oberflächen innerhalb des Vakuums, zusätzliche Reibflächen, zusätzlicher Platzbedarf in der Vakuumkammer, zusätzlicher Reinigungsaufwand und zusätzliche Anlagenkomplexität.

Zum automatischen Wenden der Linsen sind zahlreiche mechanisch wirkende Wendevorrichtungen vorgeschlagen worden. Bekannt ist beispielsweise aus der DE 39 21 672 C2 eine Vorrichtung zum Halten und Wenden von Linsen, insbesondere Brillenglaslinsen, in einer Hochvakuum-Aufdampfanlage, mit einem gefederten Ringpaar als Linsenhalter. Der Linsenhalter wird in einem kalottenförmigen Trägerblech auf einer Drehachse gelagert, auf der sich fest verbunden ein Zahnrad befindet und die in einem rechtwinklig gekrümmten Finger endet. Der Finger kommt auf dem Trägerblech zur Auflage und begrenzt somit die Rotationsmöglichkeit der Achse auf etwa 180°. Über die mechanische Einwirkung eines über dem Trägerblech befindlichen Rechens auf das Zahnrad kann die Drehachse rotiert werden, wobei der Linsenhalter mit samt der Linse gewendet wird. Um einen wiederholten mechanischen Kontakt bei jeder Kalottenumdrehung zu vermeiden wird für den Wendevorgang neben den einzelnen Linsenhaltern auch der Rechen mechanisch bewegt.

Weiterhin ist aus der DE 37 15 831 A1 eine Vakuumbeschichtungsanlage bekannt, bei der die Segmente der Kalotte gewendet werden, wobei die darin befestigten Linsenhalter nur geringfügig um eine eigene Drehachse kippen, um eine bestmögliche Orientierung der jeweiligen Linsenseite in Bezug auf die Aufdampfquelle vor und nach dem Wenden zu erhalten.

Die US 3,396,696 offenbart ein Wenden einer Vielzahl an Linsenhaltern mit Hilfe eines Magneten. Die Linsenhalter sind an einem rotierbaren Träger angebracht. Bei Stillstand des Trägers kann mit Hilfe des Magneten eine Welle bewegt werden, welche die Linsenhalter über jeweils zugeordnete Getriebe wendet.

Darüber hinaus ist eine Vielzahl von mechanischen Wendevorrichtungen bekannt, welche einen Großteil der für die Bedampfung in der Bedampfungsanlage zur Verfügung stehenden Fläche beanspruchen. Die damit verbundene Kapazitätsverringerung steht dem Vorteil der Verkürzung des Gesamtvorganges der Beschichtung beider Linsenseiten entgegen.

Der vorliegenden Erfindung liegt daher die Aufgabe zugrunde, eine Vorrichtung sowie ein Verfahren bereitzustellen, bei der bzw. bei dem die verfahrenstechnischen Vorteile von Trägerblechen ohne Wendevorrichtung mit dem Vorteil der Durchsatzerhöhung mittels Wendevorrichtung verknüpft sind. Darüber hinaus soll eine besonders geeignete Verwendung der Vorrichtung bzw. des Verfahrens vorgestellt werden.

Diese Aufgabe wird durch eine Vorrichtung zum Wenden eines Gegenstands, insbesondere von ophthalmischen Kunststofflinsen, in einer Vakuumbeschichtungsanlage mit den Merkmalen des Patentanspruchs 1 oder eine Vorrichtung mit den Merkmalen des Patentanspruchs 2, ein Verfahren zum Wenden eines Gegenstands, insbesondere von ophthalmischen Kunststofflinsen, in einer Vakuumbeschichtungsanlage mit den Merkmalen des Patentanspruchs 11 oder ein Verfahren mit den Merkmalen des Patentanspruchs 12 sowie deren erfindungsgemäße Verwendung entsprechend dem Patentanspruch 13 gelöst.

Vorteilhafte Ausführungen und Weiterbildungen der Erfindung sind in den Unteransprüchen angegeben.

Die Erfindung sieht demgemäß eine Vorrichtung zum Wenden eines Gegenstands, insbesondere einer ophthalmischen Kunststofflinse, in einer Vakuumbeschichtungsanlage mit einem auf einem um eine Drehachse drehbaren, insbesondere drehbar, gelagerten Halter für den Gegenstand und mit einer den Halter durch Drehung um die Drehachse wendenden Wendeeinrichtung vor, die einen für die Drehung des Halters um die Drehachse erforderlichen Krafterzeuger umfasst. Die Wendeeinrichtung, respektive der Krafterzeuger, erzeugt eine Kraft, welche den Halter im Gegensatz zum oben skizzierten Stand der Technik ohne mechanische Kopplung zwischen Wendeeinrichtung und Halter wendet. Im Falle der Wendevorrichtung für eine ophthalmische Kunststofflinse besteht demgemäß weder eine mechanische Verbindung zwischen Krafterzeuger und Linsenhalter bzw. zwischen Krafterzeuger und Linse noch sind mechanisch bewegliche Bauteile bzw. Komponenten zum Übertragen der Kraft zwischen Krafterzeuger und Linsenhalter bzw. Linse vorgesehen. Dabei ist der Träger zum Wenden des Halters bewegbar, ohne dass der Träger selbst gewendet wird. Alternativ oder zusätzlich ist der Krafterzeuger zum Wenden des Halters relativ zur Drehachse des Halters bewegbar (z.B. auch ohne dass der Träger selbst gewendet wird).

Geht man z.B. konkret von einer Vorrichtung zum Halten und Wenden von Linsen, insbesondere für in einer Hochvakuum-Aufdampfungsanlage oder -Sputteranlage zu beschichtenden Brillenglaslinsen, mit einem um eine Drehachse wendbaren und auf einem rotierbaren in der Prozesskammer der Hochvakuum-Anlage angeordneten Träger gelagerten Linsenhalter aus, so ist erfindungsgemäß vorgesehen, dass die Kraft, die, neben der Kraft zum Antrieb des rotierbaren Trägers, zur Drehung des Linsenhalters mit eingespannter Linse um die eigene Drehachse erforderlich ist ohne mechanische Verbindung zwischen Krafterzeuger und Linsenhalter bzw. zwischen Krafterzeuger und Linse übertragen wird. Trägerbleche können erstens mit vergleichsweise kleinen, einfachen, nicht beweglichen Aufbauten modifiziert werden, die die Kapazität gegenüber einer vergleichbaren Kalotte ohne Wendevorrichtung nicht oder nur geringfügig verringern. Die Kraft für die Wendebewegung auf den Linsenhalter kann zweitens ohne zusätzliche mechanisch bewegliche Bauteile übertragen werden und die Reibflächen und Reibkräfte bei der Drehung eines Linsenhalters können drittens so klein gehalten werden, dass Verschmutzungen der Linsen durch Abriebpartikel vernachlässigbar sind. Zum vollständigen Wenden des Halters wird zusätzlich die Rotationsbewegung des rotierbaren Trägers oder eine relative Bewegung des Krafterzeugers in Bezug auf die Drehachse des Halters genutzt, ohne dass der Träger selbst gewendet wird.

Entsprechend erfolgt das Wenden eines Gegenstands, insbesondere einer ophthalmischen Kunststofflinse, in einer Vakuumbeschichtungsanlage erfindungsgemäß mit folgenden Verfahrensschritten:
a) Haltern des Gegenstands mit einem auf einem Träger um eine Drehachse drehbaren, z.B. drehbar gelagerten Halter
b) Wenden des den Gegenstand halternden Halters durch Drehung um die Drehachse. Das Wenden des den Gegenstand halternden Halters wird dabei mit einer Kraft ohne mechanische Kopplung zum Halter durchgeführt. Die Drehung des Halters um die Drehachse erfolgt mit einer von einem Krafterzeuger erzeugten Kraft, welche ohne mechanisch bewegliche Komponenten auf den Halter übertragen wird. Dabei kann der Träger zum Wenden des Halters linear oder rotatorisch bewegt werden, ohne dass er selbst gewendet wird. Alternativ oder zusätzlich kann der Krafterzeuger zum Wenden des Halters relativ zur Drehachse des Halters linear oder drehend bewegt werden.

Die Kraft, welche den Halter nach der Erfindung ohne mechanische Kopplung zwischen Wendeeinrichtung und Halter wendet, umfasst die Trägheitskraft. Alternativ oder zusätzlich umfasst diese Kraft die magnetische Kraft eines Permanentmagneten oder einer mit Hilfe eines elektrischen Stromes angeregten Magnetspule. Im ersten Fall wird der Halter derart beschleunigt oder abgebremst, dass sich der Halter in Folge seiner Trägheit wendet. Im zweiten Fall wird der Halter durch magnetische Wechselwirkung gewendet. Beide Varianten zeichnen sich durch eine berührungslose Kraftübertragung für den Wendevorgang aus. Das Bestücken der Vakuumbeschichtungsanlage mit den zu beschichtenden Gegenständen wird auf diese Weise sehr vereinfacht, da keine mechanische Verbindung hergestellt zu werden braucht. Das Herstellen einer mechanischen Verbindung kann nämlich üblicherweise nur manuell erfolgen und ist daher zeitintensiv und fehleranfällig.

In einem besonders vorteilhaften Ausführungsbeispiel kann ein rotierbarer Träger, insbesondere eine Kalotte, vorgesehen sein, auf dem der Halter um die Drehachse drehbar (gelagert) ist. Die Rotationsbewegung des Trägers kann nun zum Wenden des den Gegenstand halternden Halters verwendet werden. Selbstverständlich kann der Träger auch linear beweglich ausgeführt sein, nämlich z.B. wenn er Bestandteil einer Durchlaufbeschichtungsanlage ist.

In der oben beschriebenen ersten Variante wird die Kraft, die zur Drehung des Halters mit eingespanntem Gegenstand um die eigene Drehachse erforderlich ist, durch eine negative oder positive Beschleunigung der Bewegung des Trägers (z.B. der Rotationsbewegung wenn der Träger rotierbar ist oder der Linearbewegung wenn der Träger linear bewegbar ist) hervorgerufen. Anders ausgedrückt wird der Träger rotatorisch oder linear derart beschleunigt oder abgebremst, dass sich der Halter in Folge seiner Massenträgheit um seine Drehachse dreht und den gehalterten Gegenstand dabei wendet. Diese Variante zeichnet sich dadurch aus, dass sie bei herkömmlichen Vorrichtungen der oben beschriebenen Art leicht implementiert werden kann. Hierzu genügt in der Regel eine geeignete Ansteuerung des rotierbaren Trägers.

Eine besonders vorteilhafte Ausführung dieser Variante besteht darin, dafür zu sorgen, dass der Schwerpunkt des den Gegenstand halternden Halters höher als der Mittelpunkt der Drehachse des Halters liegt. Beim Beschleunigen oder Abbremsen des (z.B. rotierbaren oder linear) bewegbaren Trägers dreht sich der Halter damit zwangsläufig ohne weitere äußere Kräfte um seine Drehachse in die vorgesehene Richtung.

In der oben beschriebenen zweiten Variante wird die Kraft, die zur Drehung des Halters mit eingespanntem Gegenstand um die eigene Drehachse erforderlich ist, durch magnetische Wechselwirkung hervorgerufen. Anders ausgedrückt wird z.B. der Träger bei seiner Rotations- oder Linearbewegung durch ein magnetisches Kraftfeld geführt. Es ist vorgesehen, dass der Halter bei der Rotations- oder Linearbewegung des Trägers derart mit der magnetischen Kraft wechselwirkt, dass sich der Halter wendet. Alternativ kann auch der magnetische Krafterzeuger drehend oder linear bewegt werden. Maßgeblich ist allein eine Relativbewegung zwischen Krafterzeuger und Drehachse des Halters. Auch diese Variante zeichnet sich dadurch aus, dass eine herkömmliche Anlage der oben beschriebenen Art durch eine einfache Modifikation nachgerüstet werden kann.

Zur Erzeugung der magnetischen Kraft kann, wie vorstehend bereits angedeutet wurde, eine Magnetspule und/oder ein Permanentmagnet vorgesehen werden. Ein Permanentmagnet lässt sich sowohl am Halter (oder dem zu halternden Gegenstand) als auch mit Abstand zu diesem anbringen, während eine Magnetspule aufgrund deren Bestromung vorzugsweise beabstandet zu dem Halter angeordnet sein wird, wenngleich auch deren Anordnung am Halter bei gewissen Anwendungen Vorteile haben mag. Die Wechselwirkung von Magnetspule und/oder Permanentmagnet und/oder einem magnetisierbaren Teil am Halter mit einer Magnetspule und/oder Permanentmagnet und/oder einem magnetisierbaren Teil in einem Abstand zum Halter wird zum Wenden des Halters ausgenutzt.

Vorzugsweise ist/sind die Magnetspule und/oder der Permanentmagnet (insbesondere wenn von unten nach oben beschichtet wird) oberhalb des (z.B. rotierbaren) Trägers angebracht. Zum einen wird auf diese Weise eine Beschichtung von Magnetspule und/oder Permanentmagnet verhindert oder zumindest reduziert, zum anderen ist dort üblicherweise hinreichend Platz, um Magnetspule und/oder Permanentmagnet anzuordnen. Für den seltenen Fall, dass von oben nach unten beschichtet wird, befindet sich die Magnetspule und/oder der Permanentmagnet vorzugsweise unterhalb des Trägers.

Wie bei herkömmlichen Anlagen üblich kann der Halter einen Haltering aufweisen, welcher den Gegenstand ringförmig umschlossen hält. Die von der Magnetspule und/oder von dem Permanentmagneten an der unteren Austrittsseite der Magnetfeldlinien umschlossene Fläche beträgt dann vorzugsweise mindestens das 0,2-fache der vom Haltering umschlossenen Fläche. Diese Maßnahme stellt eine hinreichende Bedingung für eine möglichst geringe entfernungsabhängige Abnahme der auf den Halter wirkenden magnetischen Feldstärke dar, was wiederum die Auslegung des Magnetfelderzeugers bezüglich der Erreichung der für den Wendevorgang notwendigen Magnetfeldstärke begünstigt.

Bei einer besonders vorteilhaften Ausführungsvariante einer auf einer magnetischen Wechselwirkung basierenden Wendeeinrichtung ist vorgesehen, dass der Halter einen magnetisierbaren, insbesondere ferromagnetischen Teil besitzt. Der magnetisierbare, insbesondere ferromagnetische Teil des Halters kann entweder ein fester Bestandteil des Halters sein oder als Einzelteil an den Halter angebracht sein.

Es hat sich als günstig erwiesen, wenn der magnetisierbare, insbesondere ferromagnetische Teil des Halters nur auf einer der beiden durch die Drehachse des Halters unterteilten Seiten des Halters positioniert ist, sodass nur auf diese Seite das zum Wenden vorgesehene Magnetfeld effektiv wirken kann und somit keine sich entgegenwirkenden Kräfte auftreten, die durch das Magnetfeld hervorgerufen werden.

In Fällen, in denen am Halter selbst kein magnetisierbarer, insbesondere ferromagnetischer Teil angebracht werden kann, kann ein magnetisierbarer, insbesondere ferromagnetischer Teil auch an dem Gegenstand, insbesondere der ophthalmischen Kunststofflinse, angebracht sein. Es ist auch möglich, etwaig vorhandene magnetisierbare bzw. ferromagnetische Eigenschaften des Gegenstands selbst für den vorstehend beschriebenen Zweck des Wendens auszunutzen.

Unter Ausnutzung der Rotation des Kalottenträgers ist der Kraftaufwand zum Wenden des Halters am geringsten, wenn die Drehachse des Halters senkrecht, d. h. in einem Winkel von 90°, in Bezug auf die Tangente einer Rotationslinie des Trägers (z. B. einer Kalotte) orientiert ist, wobei die Rotationslinie eine gedachte Linie ist, die durch die Bewegung des Mittelpunkts der Drehachse eines in den Träger (z. B. der Kalotte) eingelegten Halters während der Rotation des Trägers (z. B. der Kalotte) entsteht. Für die Lagerung des Halters auf dem Träger (z. B. der Kalotte) ist an einem oder beiden Enden der Drehachse ein Platz auf dem Träger (z. B. der Kalotte) erforderlich. Um möglichst viele Halter auf dem Träger (z. B. der Kalotte) unterzubringen, kann daher aus Platzgründen eine abweichende Orientierung der Drehachse des Halters in Bezug auf die Tangente der Rotationslinie vorteilhaft sein, nämlich in einem Winkelbereich von 0° bis 90°, wobei 0° einer Orientierung der Drehachse des Halters parallel zur Tangente der oben genannten Rotationslinie entspricht.

An der Außenseite des Halters können zwei sich gegenüberliegende Naben angebracht sein, die die beiden Enden der Drehachse des Halters bilden. Die Anbringung der Naben an der Außenseite des Halters hat den Vorteil, ein möglichst großes Verhältnis von in den Halter aufnehmbarer Linsengröße zu den Abmessungen des Halters, d. h. des Platzbedarfs des Halters auf dem Träger, zu schaffen.

Jede Nabe liegt vorzugsweise innerhalb eines Lagers, das jeweils mit dem Träger (z.B. der Kalotte) verbunden ist, wobei beide Lager rund um die Naben geschlossen sind und das auf dem Träger tiefer liegenden der beiden Lager am unteren Ende mit einem Abschlussstück versehen ist. Die um die Nabe geschlossenen Lager verhindern ein mögliches Heraustreten des Halters aus der Lagerung durch die beim Wendevorgang wirkenden Flieh- oder Magnetkräfte. Das Abschlussstück am unteren Ende des tiefer liegenden Lagers dient als Auflagepunkt des Endes der darin befindlichen Nabe um den Halter in einer definierten Position drehbar in der Aussparung des Trägers zu halten, d.h. in einer Position, in der der Wendevorgang nicht durch einen Kontakt zwischen Halter und Träger behindert wird.

Die im höher liegenden Lager befindliche Nabe ist vorzugsweise länger als die im tiefer liegenden Lager, weil dadurch ein gegen ein Herausfallen des Halters gesicherter, ausreichend tiefer Sitz beider Naben in den Lagern gewährleistet wird. Dies kann einen Vorteil darstellen, ist für die Funktionalität aber nicht zwingend erforderlich. Die im höher liegenden Lager einzubringende Nabe wird beim Einlegen des Halters zuerst eingebracht um anschließend die zweite Nabe vor die Öffnung des tiefer liegenden, am unteren Ende geschlossenen Lagers zu führen. Schwerkraftunterstützt wird der Halter anschließend bis an das Abschlussstück des unteren Lagers geführt. Dabei bewegt sich die im höher liegenden Lager befindliche Nabe um die innere Länge des tiefer liegenden Lagers aus dem höher liegenden Lager heraus. Durch dieses Herausbewegen verringert sich die Tiefe des Sitzes der im höher liegenden Lager befindlichen Nabe.

Es hat sich als besonders vorteilhaft herausgestellt, wenn der Halter in seiner Auflageebene im Träger senkrecht zu seiner Drehachse asymmetrisch aufgebaut ist, derart, dass in Bezug auf die Drehachse, eine Seite schwerer ist als die andere und die schwerere Seite des Halters auf dem Träger aufliegt während die andere Seite den Träger nicht berührt. Auf diese Weise befindet sich der Schwerpunkt des Halters in der genannten Ebene außerhalb der Drehachse auf der schwereren Seite des Halters. Diese Schwerpunktlage in Kombination mit der einseitigen Auflage auf dem Träger unterdrückt ein Aufrichten oder ungewolltes Wenden während der Beschichtung, auch wenn der Träger (z. B. die Kalotte) mit ausreichend mäßiger Geschwindigkeit rotiert. Andererseits kann diese Schwerpunktlage zu einem Aufrichten und anschließenden Wenden genutzt werden, wenn der Träger (z. B. die Kalotte) mit ausreichend hoher Geschwindigkeit rotiert und anschließend abgebremst wird.

Bevorzugt bildet die auf dem Träger aufliegende Seite, bzw. ein Teil dieser Seite, den magnetisierbaren Teil des Halters um diesen Teil beim Wendevorgang oberhalb des Trägers bewegen zu können, um wiederum die oben beschriebenen Vorteile eines oberhalb des Trägers angebrachten Magnetfelderzeugers zu nutzen.

Die vorstehend angegebene Vorrichtung bzw. das vorstehend beschriebene Verfahren wird erfindungsgemäß bevorzugt zum Wenden von optischen Elementen, wie z.B. ophthalmischen Linsen, verwendet.

Die Erfindung wird nunmehr anhand der Zeichnung näher beschrieben. Es zeigen:
- Figur 1: eine Prozesskammer einer Hochvakuum-Aufdampfanlage mit einer erfindungsgemäßen Vorrichtung zum Wenden von ophthalmischen Kunststofflinsen,
- Figur 2: die Vorrichtung zum Wenden von ophthalmischen Kunststofflinsen in vergrößerter und perspektivischer Darstellung.

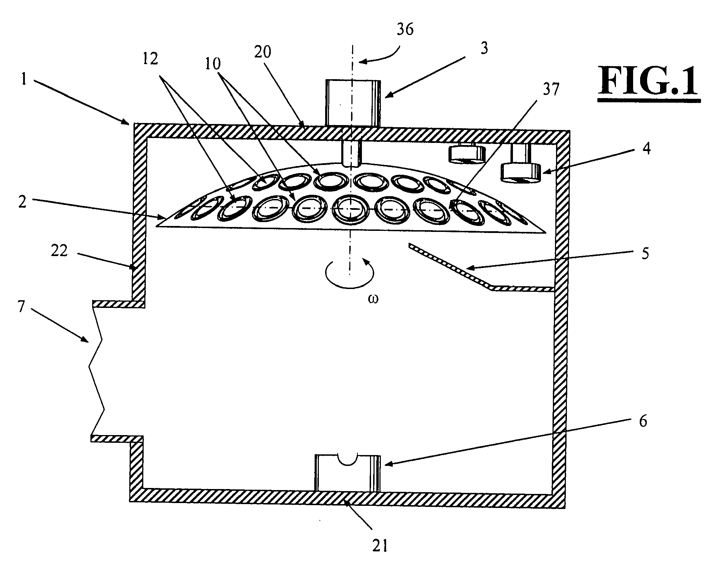

Figur 1 stellt schematisch den Aufbau einer Hochvakuumbedampfungsanlage für Brillenglaslinsen 12 dar. An der Deckenplatte 20 der im Querschnitt dargestellten Vakuumkammer 1 ist die Kalotte 2 mit Linsenhaltern 10 und Linsen 12 an einem Antriebsmodul 3 angebracht, das die Kalotte 2 in Rotationsbewegung ω um ihre Symmetrieachse (Rotationsachse 36) versetzt. An der Deckenplatte 20, oberhalb der Kalotte 2, sind weiterhin eine oder mehrere Magnetspulen 4 angebracht. Von der am Boden 21 der Vakuumkammer 1 befindlichen Verdampferquelle 6 aus gesehen befinden sich die Magnetspulen 4 hinter einer Blende 5, um eine Bedampfung der Magnetspulen 4 weitgehend zu vermeiden. In der Verdampferquelle 6 wird das Aufdampfmaterial (nicht dargestellt) bis zum Verdampfen oder Sublimieren erhitzt, z. B. mittels einer elektrischen Heizung (nicht dargestellt) oder mittels eines Elektronenstrahls (nicht dargestellt). Eingezeichnet ist auch eine Öffnung 7 in einer seitlichen Wand 22 der Vakuumkammer 1, die zum Vakuumpumpensystem führt, welches selbst nicht eingezeichnet ist.

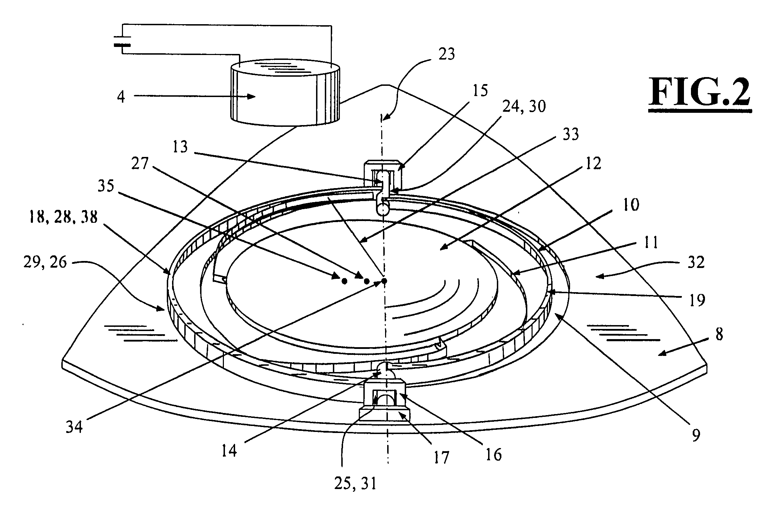

In Figur 2 ist ein Ausschnitt der Kalotte 2 dargestellt. Das Trägerblech 8 der Kalotte 2 besitzt kreisförmige Aussparungen 9 für die Linsenhalter 10. Eine Aussparung 9 ist in dem dargestellten Teilstück der Kalotte 2 beispielhaft dargestellt. Darin befindet sich ein Linsenhalter 10 bestehend aus einem größeren Halbring 18, einem kleineren Halbring 19, zwei Naben 13, 14, sowie Spannfedern 11, in die eine Linse 12 eingespannt ist. Die Halbringe 18, 19 sind jeweils an ihren Enden mit den Naben 13, 14 verbunden. Die Naben 13, 14 liegen einander gegenüber und bilden die beiden Enden der Drehachse 23 des Linsenhalters 10. Beim eingelegten Linsenhalter 10 liegt jede Nabe 13, 14 innerhalb eines Lagers 15, 16, das jeweils mit dem Trägerblech 8 verbunden ist. Das auf dem Trägerblech 8 tiefer liegende Lager 16 ist am unteren Ende mit einem Abschlussstück 17 abgeschlossen. Durch das Abschlussstück 17 und die rund um die Achsen 23 der Naben 13, 14 geschlossenen Lager 15, 16 wird der Linsenhalter 10, insbesondere bei Rotation der Kalotte 2, in der Aussparung 9 an zwei Punkten 24, 25 gehalten. Der größere Halbring 18 des Linsenhalters 10 bildet gleichzeitig den ferromagnetischen Teil 28 und verlagert aufgrund seiner gegenüber dem kleineren Halbring 19 größeren Masse den Schwerpunkt 27 des Linsenhalters 10 aus der Drehachse 23. Dadurch wird die Auflage 29 des größeren Halbrings 18 auf das Trägerblech 8 zum dritten Punkt 26 einer stabilen Dreipunktauflage, neben den beiden Auflagebereichen 30, 31 der Naben 13, 14 in den Lagern 15, 16, d. h. der größere Halbring 18 bildet die dritte Stütze 38 der Dreipunktlagerung.

Oberhalb der Kalotte 2 ist eine Magnetspule 4 angebracht. Der Abstand zwischen der Magnetspule 4 und der Kalotte 2 bzw. einer direkt unterhalb der Magnetspule 4 gelegenen Aussparung 9 der Kalotte 2 entspricht etwas mehr als dem Radius 33 des größeren Halbrings 18 des Linsenhalters 10, so dass der Wendevorgang direkt unterhalb der Magnetspulen 4 stattfinden kann. Zum Wenden des Linsenhalters 10, mitsamt einer eingebauten Linse 12, wird mittels der Spule 4 ein ausreichend starkes Magnetfeld erzeugt, dessen Feldlinien (nicht dargestellt) zumindest teilweise in Richtung der Kalotte 2 zeigen. Wird die Kalotte 2 langsam in die Richtung rotiert, in der der ferromagnetische Teil 28 des Linsenhalters 10 der Drehachse 23 des Linsenhalters 10 vorangeht, so erfolgt das Umwenden des Linsenhalters 10 wenn der Linsenhalter 10 mit der Kalottenrotation unterhalb der eingeschalteten Spule 4 hindurch bewegt wird, wobei sich der Linsenhalter 10 auf der Drehachse 23 dreht, indem er mit dem ferromagnetischen Teil 28, entsprechend des Verlaufs der Magnetfeldlinien (nicht dargestellt), auf die Spule 4 ausgerichtet wird und bleibt, bis der ferromagnetische Teil 28 auf der in Bezug auf die Ausgangslage gegenüberliegenden Seite der Aussparung 9 wieder aufliegt.

Der ferromagnetische Teil 28 kann nach dem Wendevorgang vollständig entmagnetisiert werden, z. B. durch Induktion eines zeitlich abnehmenden magnetischen Wechselfeldes mit Hilfe der vorhandenen Spule 4.

In dem gesonderten Fall, dass der Schwerpunkt 35 des Systems Linsenhalter 10 mit Linse 12 höher als der Mittelpunkt 34 der Drehachse 23 des Linsenhalters 10 liegt und bei der Rotation der Kalotte 2 die Drehachse 23 dem Schwerpunkt 35 in Rotationsrichtung voran geht, kann eine Wendung des Linsenhalters 10 auch ohne Magnetfeld bzw. ohne Magnetfelderzeuger 4 vollzogen werden, indem die Kalottenrotation so stark abgebremst wird, d. h. negativ beschleunigt wird, dass der Betrag der im Schwerpunkt 35 angesetzten, entgegen der Richtung der Gravitationskraft zeigenden Komponente des Vektors der negativen Beschleunigung größer wird, als der Betrag der im Schwerpunkt 35 angesetzten Gravitationsbeschleunigung. Die dabei resultierende Kraft führt über das Abheben der dritten Stütze 38 der Dreipunktlagerung zur 180° Drehung des Linsenhalters 10. Für diese Variante des Wendevorgangs braucht die dritte Stütze 38 der Dreipunktlagerung nicht ferromagnetisch zu sein.

Der Wendevorgang kann dadurch eingeleitet werden, dass die Rotationsgeschwindigkeit der Kalotte 2 erhöht wird, bis die im Schwerpunkt 35 des Systems Linsenhalter 10 mit Linse 12 resultierende Fliehkraft zum Anheben der dritten Stütze 18 der Dreipunktauflage ausreicht. Bei zunehmender Fliehkraft stellt sich der Linsenhalter im 90°-Winkel in Bezug zur Ausgangslage auf. Beim anschließenden Abbremsen der Kalottenrotation wird die Drehung des Linsenhalters 10 weitergeführt, bis die dritte Stütze 18 auf der in Bezug auf die Ausgangslage gegenüberliegenden Seite der Aussparung 32 wieder aufliegt (wie in der Figur 2 dargestellt ist).

Die vorliegende Erfindung besitzt die oben genannten Vorteile bekannter Wendevorrichtungen, die Effekte der Nachteile sind hingegen auf ein Minimum reduziert oder entfallen ganz, da keine beweglichen Bauteile zum Antrieb oder zur Kraftübertragung verwendet werden. Im Einzelnen werden die Vorteile gegenüber bekannten Wendevorrichtungen durch nachfolgend genannte Punkte erzielt:
Bei der Erfindung sind die Reibflächen auf ein Minimum verringert. Sie liegen in einem bezüglich der Verdampferquelle 6 abgeschatteten Bereich und werden mechanisch nur gering belastet, so dass bei erfindungsgemäßem Gebrauch keine Verschmutzung der Linsen 12 durch Reibabsplitterung entsteht. Der Aufwand für Routinereinigungen entspricht weitgehend dem für Anlagen ohne Wendemechanismus. Das Gesamtgewicht der Kalotte 2 ist nur geringfügig größer als für Anlagen ohne Wendemechanismus. Der auf dem Substratträger 2 für die Vorrichtungen zusätzlich benötigte Platz ist vergleichsweise gering, sodass die Kapazität nur geringfügig oder gar nicht verkleinert wird.

### Bezugszeichenliste

- 1: Vakuumkammer
- 2: Kalotte
- 3: Antriebsmodul
- 4: Magnetspule
- 5: Blende
- 6: Verdampferquelle
- 7: Öffnung
- 8: Trägerblech
- 9: Aussparung
- 10: Linsenhalter
- 11: Spannfeder
- 12: ophthalmische Kunststofflinse
- 13: Nabe
- 14: Nabe
- 15: Lager
- 16: Lager
- 17: Abschlussstück
- 18: größerer Halbring
- 19: kleinerer Halbring
- 20: Deckenplatte
- 21: Boden
- 22: seitliche Wand
- 23: Drehachse
- 24: erster Punkt
- 25: zweiter Punkt
- 26: dritter Punkt
- 27: Schwerpunkt des Linsenhalters
- 28: ferromagnetischer Teil
- 29: Auflage
- 30: Auflage
- 31: Auflage
- 32: Auflage
- 33: Radius des größeren Halbrings
- 34: Mittelpunkt der Drehachse
- 35: Schwerpunkt des Systems Linse und Linsenhalter
- 36: Rotationsachse
- 37: Rotationslinie
- 38: Stütze

## Patentansprüche

1. Vorrichtung, die zum Wenden eines Gegenstands (12) in einer Vakuumbeschichtungsanlage geeignet ist,
- mit einem auf einem Träger (2) um eine Drehachse (23) drehbaren Halter (10) für den Gegenstand (12) und
- mit einer den Halter (10) durch Drehung um die Drehachse (23) wendenden Wendeeinrichtung (2), die einen für die Drehung des Halters (10) um die Drehachse (23) erforderlichen Krafterzeuger (2) beinhaltet,
**dadurch gekennzeichnet, dass**
- der Krafterzeuger (2) eine Kraft zur Drehung des Halters (10) um die Drehachse (23) erzeugt, welche ohne mechanisch bewegliche Bauteile vom Krafterzeuger (2) auf den Halter (10) übertragen wird, wobei die Kraft eine Trägheitskraft umfasst und dass
- der Träger (2) zum Wenden des Halters (10) bewegbar ist, ohne dass der Träger (2) selbst gewendet wird, wobei
- der Träger (2) linear bewegbar oder rotierbar ausgebildet ist, wobei die Linearbewegung oder die Rotationsbewegung (ω) des Trägers (2) derart beschleunigbar oder abbremsbar ist, dass sich der Halter (10) wendet.

2. Vorrichtung, die zum Wenden eines Gegenstands (12) in einer Vakuumbeschichtungsanlage geeignet ist,
- mit einem auf einem Träger (2) um eine Drehachse (23) drehbaren Halter (10) für den Gegenstand (12) und
- mit einer den Halter (10) durch Drehung um die Drehachse (23) wendenden Wendeeinrichtung (4, 28), die einen für die Drehung des Halters (10) um die Drehachse (23) erforderlichen Krafterzeuger beinhaltet,
**dadurch gekennzeichnet, dass**
- der Krafterzeuger (4, 28) eine Kraft zur Drehung des Halters (10) um die Drehachse (23) erzeugt, welche ohne mechanisch bewegliche Bauteile vom Krafterzeuger (4, 28) auf den Halter (10) übertragen wird, wobei die Kraft eine magnetische Kraft umfasst und dass
- der Träger (2) zum Wenden des Halters (10) bewegbar ist, ohne dass der Träger (2) selbst gewendet wird, wobei der Träger (2) linear bewegbar oder rotierbar ausgebildet ist, wobei der Halter (10) bei der Linearbewegung oder Rotation des Trägers (2) derart mit der magnetischen Kraft wechselwirkt, dass sich der Halter (10) wendet und/oder dass
der Krafterzeuger (4, 28) zum Wenden des Halters (10) relativ zu der Drehachse (23) des Halters (10) linear oder drehend bewegbar ist und der Halter (10) durch magnetische Wechselwirkung gewendet wird.

3. Vorrichtung nach Anspruch 2, **dadurch gekennzeichnet, dass** zur Erzeugung der magnetischen Kraft eine Magnetspule (4) und/oder ein Permanentmagnet vorgesehen ist.

4. Vorrichtung nach Anspruch 3, **dadurch gekennzeichnet, dass** die Magnetspule (4) und/oder der Permanentmagnet oberhalb des Trägers (2) angebracht ist.

5. Vorrichtung nach einem der Ansprüche 2 bis 4, **dadurch gekennzeichnet, dass** der Halter (10) einen magnetisierbaren, insbesondere ferromagnetischen Teil (28) besitzt.

6. Vorrichtung nach Anspruch 5, **dadurch gekennzeichnet, dass** der magnetisierbare, insbesondere ferromagnetische Teil (28) des Halters (10) ein insbesondere materialeinheitlicher Bestandteil des Halters (10) ist oder als Einzelteil an den Halter (10) angebracht ist.

7. Vorrichtung nach Anspruch 4 oder 5, **dadurch gekennzeichnet, dass** der magnetisierbare, insbesondere ferromagnetische Teil (28) des Halters (10) als einziger Teil (28) des Halters (10) magnetisierbar, insbesondere ferromagnetisch ist.

8. Vorrichtung nach einem der Ansprüche 2 bis 7, **dadurch gekennzeichnet, dass** ein magnetisierbarer, insbesondere ferromagnetischer Teil an dem Gegenstand (12) angebracht ist.

9. Vorrichtung nach einem der vorangegangenen Ansprüche, **dadurch gekennzeichnet, dass** die Drehachse (23) des Halters (10) in einem Winkelbereich von 0° bis 90° in Bezug auf die Tangente einer Rotationslinie (37) des Trägers (2) orientiert ist, wobei eine Rotationslinie (37) eine gedachte Linie ist, die durch die Bewegung des Mittelpunkts (34) der Drehachse (23) eines in den Träger (2) eingelegten Halters (10) während der Rotation (ω) des Trägers (2) entsteht.

10. Vorrichtung nach einem der vorangegangenen Ansprüche, **dadurch gekennzeichnet, dass** an der Außenseite des Halters (10) zwei sich gegenüberliegende Naben (13, 14) angebracht sind, die die beiden Enden der Drehachse (23) des Halters (10) bilden.

11. Verfahren zum Wenden eines Gegenstands (12) in einer Vakuumbeschichtungsanlage mit folgenden Verfahrensschritten:
- Haltern des Gegenstands (12) mit einem auf einem Träger (2) um eine Drehachse (23) drehbaren Halter (10)
- Wenden des den Gegenstand (12) halternden Halters (10) durch die Drehung um die Drehachse (23),
**dadurch gekennzeichnet, dass**
- die Drehung des Halters (10) um die Drehachse (23) mit einer von einem Krafterzeuger (2) erzeugten Kraft durchgeführt wird, welche ohne mechanisch bewegliche Bauteile auf den Halter (10) übertragen wird, wobei die Kraft eine Trägheitskraft umfasst und dass
- der Träger (2) zum Wenden des Halters (10) linear oder rotatorisch bewegt wird, ohne dass der Träger (2) selbst gewendet wird, wobei die Linearbewegung oder die Rotationsbewegung (ω) des Trägers (2) derart beschleunigt oder abgebremst wird, dass sich der Halter (10) wendet.

12. Verfahren zum Wenden eines Gegenstands (12) in einer Vakuumbeschichtungsanlage mit folgenden Verfahrensschritten:
- Haltern des Gegenstands (12) mit einem auf einem Träger (2) um eine Drehachse (23) drehbaren Halter (10)
- Wenden des den Gegenstand (12) halternden Halters (10) durch die Drehung um die Drehachse (23),
**dadurch gekennzeichnet, dass**
- die Drehung des Halters (10) um die Drehachse (23) mit einer von einem Krafterzeuger (4,22) erzeugten Kraft durchgeführt wird, welche ohne mechanisch bewegliche Bauteile auf den Halter (10) übertragen wird, wobei die Kraft eine magnetische Kraft umfasst und dass
- der Träger (2) zum Wenden des Halters (10) linear oder rotatorisch bewegt wird, ohne dass der Träger (2) selbst gewendet wird und der Halter (10) bei der Linearbewegung oder Rotation des Trägers (2) derart mit der magnetischen Kraft wechselwirkt, dass sich der Halter (10) wendet und/oder dass der Krafterzeuger (4,22) zum Wenden des Halters (10) relativ zu der Drehachse (23) des Halters (10) linear oder drehend bewegt wird und der Halter (10) durch magnetische Wechselwirkung gewendet wird.

13. Verwendung einer Vorrichtung nach einem der Ansprüche 1 bis 10 oder eines Verfahrens nach einem der Ansprüche 11 oder 12 zum Wenden von optischen Elementen (12), insbesondere ophthalmischen Linsen (12), in einer Vakuumbeschichtungsanlage vor deren Beschichtung und/oder während deren Beschichtung und/oder nach deren Beschichtung.

## Claims

1. Apparatus, suitable for turning an article (12) in a vacuum coating installation,
- comprising a holder (10) for the article (12), which holder is rotatable on a support (2) about an axis of rotation (23), and
- comprising a turning device (2) which turns the holder (10) by a rotation about the axis of rotation (23), which turning device contains a force generator (2) which is required for rotating the holder (10) about the axis of rotation (23),
**characterized in that**
- the force generator (2) generates a force for rotating the holder (10) about the axis of rotation (23), which force is transferred from the force generator (2) to the holder (10) without mechanically movable components, the force comprising an inertial force, and **in that**
- the support (2) is movable for turning the holder (10), without the support (2) itself being turned, wherein
- the support (2) has a linearly movable or rotatable embodiment, wherein the linear movement or the rotational movement (ω) of the support (2) is accelerable or decelerable in such a way that the holder (10) turns.

2. Apparatus, suitable for turning an article (12) in a vacuum coating installation,
- comprising a holder (10) for the article (12), which holder is rotatable on a support (2) about an axis of rotation (23), and
- comprising a turning device (4, 28) which turns the holder (10) by a rotation about the axis of rotation (23), which turning device contains a force generator which is required for rotating the holder (10) about the axis of rotation (23),
**characterized in that**
- the force generator (4, 28) generates a force for rotating the holder (10) about the axis of rotation (23), which force is transferred from the force generator (4, 28) to the holder (10) without mechanically movable components, the force comprising a magnetic force, and **in that**
- the support (2) is movable for turning the holder (10), without the support (2) itself being turned, wherein the support (2) has a linearly movable or rotatable embodiment, wherein the holder (10) interacts with the magnetic force during the linear movement or rotation of the support (2) in such a way that the holder (10) turns, and/or **in that** the force generator (4, 28) is movable relative to the axis of rotation (23) of the holder (10) in a linear or rotating manner for the purposes of turning the holder (10) and the holder (10) is turned by a magnetic interaction.

3. Apparatus according to Claim 2, **characterized in that** a magnetic coil (4) and/or a permanent magnet is provided for generating the magnetic force.

4. Apparatus according to Claim 3, **characterized in that** the magnetic coil (4) and/or the permanent magnet is attached above the support (2).

5. Apparatus according to one of Claims 2 to 4, **characterized in that** the holder (10) has a magnetizable part (28), in particular a ferromagnetic part.

6. Apparatus according to Claim 5, **characterized in that** the magnetizable part (28), in particular the ferromagnetic part, of the holder (10) is a component, in particular with a uniform material, of the holder (10) or it is attached to the holder (10) as an individual part.

7. Apparatus according to Claim 4 or 5, **characterized in that** the magnetizable part (28), in particular the ferromagnetic part, of the holder (10) is the only part (28) of the holder (10) which is magnetizable, in particular ferromagnetic.

8. Apparatus according to one of Claims 2 to 7, **characterized in that** a magnetizable part, in particular a ferromagnetic part, is attached to the article (12).

9. Apparatus according to one of the preceding claims, **characterized in that** the axis of rotation (23) of the holder (10) is oriented in an angular range from 0° to 90° in relation to the tangent of a line of rotation (37) of the support (2), wherein a line of rotation (37) is an imaginary line which arises during the rotation (ω) of the support (2) as a result of the movement of the centre point (34) of the axis of rotation (23) of a holder (10) inserted into the support (2).

10. Apparatus according to one of the preceding claims, **characterized in that** two opposing hubs (13, 14) are attached to the outer side of the holder (10), which hubs form the two ends of the axis of rotation (23) of the holder (10).

11. Method for turning an article (12) in a vacuum coating installation, comprising the following method steps:
- holding the article (12) with a holder (10) on a support (2), which holder is rotatable about an axis of rotation (23),
- turning the holder (10) holding the article (12) by way of the rotation about the axis of rotation (23),
**characterized in that**
- the rotation of the holder (10) about the axis of rotation (23) is carried out by means of a force generated by a force generator (2), which force is transferred to the holder (10) without mechanically movable components, the force comprising an inertial force, and **in that**
- the support (2) is moved linearly or rotationally for the purposes of turning the holder (10), without the support (2) itself being turned, with the linear movement or the rotational movement (ω) of the support (2) being accelerated or decelerated in such a way that the holder (10) turns.

12. Method for turning an article (12) in a vacuum coating installation, comprising the following method steps:
- holding the article (12) with a holder (10) on a support (2), which holder is rotatable about an axis of rotation (23),
- turning the holder (10) holding the article (12) by way of the rotation about the axis of rotation (23),
**characterized in that**
- the rotation of the holder (10) about the axis of rotation (23) is carried out by means of a force generated by a force generator (4, 22), which force is transferred to the holder (10) without mechanically movable components, the force comprising a magnetic force, and **in that**
- the support (2) is moved linearly or rotationally for the purposes of turning the holder (10), without the support (2) itself being turned, and the holder (10) interacts with the magnetic force during the linear movement or rotation of the support (2) in such a way that the holder (10) turns and/or **in that** the force generator (4, 22) is moved in a linear or rotating manner for the purposes of turning the holder (10) relative to the axis of rotation (23) of the holder (10) and the holder (10) is turned by magnetic interaction.

13. Use of a device according to one of Claims 1 to 10 or of a method according to either of Claims 11 and 12 for turning optical elements (12), in particular ophthalmic lenses (12), in a vacuum coating installation prior to the coating of said elements and/or during the coating of said elements and/or after the coating of said elements.

## Revendications

1. Dispositif qui convient pour retourner un objet (12) dans une installation de revêtement sous vide,
- avec un appui (10) pour l'objet (12), pouvant tourner autour de l'axe de rotation (23) sur un support (2) et
- avec un dispositif de retournement (2) retournant l'appui (10) par rotation autour de l'axe de rotation (23), qui comporte un générateur de force (2) nécessaire pour la rotation de l'appui (10) autour de l'axe de rotation (23),
**caractérisé en ce que**
- le générateur de force (2) produit une force pour la rotation de l'appui (10) autour de l'axe de rotation (23), qui est transmise sans pièces mécaniquement mobiles du générateur de force (2) à l'appui (10), dans lequel la force comprend une force d'inertie, et que
- le support (2) est mobile pour retourner l'appui (10), sans que le support (2) lui-même soit retourné, dans lequel
- le support (2) peut se déplacer linéairement ou tourner, dans lequel le mouvement linéaire ou le mouvement de rotation (ω) du support (2) peut être accéléré ou freiné de telle manière que l'appui (10) se retourne.

2. Dispositif, qui convient pour retourner un objet (12) dans une installation de revêtement sous vide,
- avec un appui (10) pour l'objet (12), pouvant tourner autour d'un axe de rotation (23) sur un support (2) et
- avec un dispositif de retournement (4, 28) retournant l'appui (10) par rotation autour de l'axe de rotation (23), qui comporte un générateur de force nécessaire pour la rotation de l'appui (10) autour de l'axe de rotation (23),
**caractérisé en ce que**
- le générateur de force (4, 28) produit une force pour la rotation de l'appui (10) autour de l'axe de rotation (23), qui est transmise sans pièces mécaniquement mobiles du générateur de force (4, 28) à l'appui (10), dans lequel la force comprend une force magnétique, et que
- le support (2) est mobile pour retourner l'appui (10), sans que le support (2) lui-même soit retourné, dans lequel le support (2) peut se déplacer linéairement ou tourner, dans lequel l'appui (10) interagit avec la force magnétique, lors du mouvement linéaire ou de la rotation du support (2), de telle manière que l'appui (10) se retourne, et/ou que
- le générateur de force (4, 28) est mobile linéairement ou en rotation par rapport à l'axe de rotation (23) de l'appui (10) pour le retournement de l'appui (10) et l'appui (10) est retourné par interaction magnétique.

3. Procédé selon la revendication 2, **caractérisé en ce qu'**il est prévu une bobine magnétique (4) et/ou un aimant permanent pour la production de la force magnétique.

4. Dispositif selon la revendication 3, **caractérisé en ce que** la bobine magnétique (4) et/ou l'aimant permanent est installé(e) au-dessus du support (2).

5. Dispositif selon l'une quelconque des revendications 2 à 4, **caractérisé en ce que** l'appui (10) comporte une partie magnétisable, en particulier ferromagnétique (28).

6. Dispositif selon la revendication 5, **caractérisé en ce que** la partie magnétisable, en particulier ferromagnétique (28) de l'appui (10) est un composant de même matière de l'appui (10) ou est installée en tant que pièce détachée sur l'appui (10).

7. Dispositif selon la revendication 4 ou 5, **caractérisé en ce que** la partie magnétisable, en particulier ferromagnétique (28) de l'appui (10) est magnétisable, en particulier ferromagnétique, en tant que pièce isolée (28) de l'appui (10).

8. Dispositif selon l'une quelconque des revendications 2 à 7, **caractérisé en ce qu'**une pièce magnétisable, en particulier ferromagnétique est installée sur l'objet (12).

9. Dispositif selon l'une quelconque des revendications précédentes, **caractérisé en ce que** l'axe de rotation (23) de l'appui (10) est orienté dans une plage angulaire de 0° à 90° par rapport à la tangente à une ligne de rotation (37) du support (2), dans lequel une ligne de rotation (37) est une ligne virtuelle, qui fait son apparition par le mouvement du point central (34) de l'axe de rotation (23) d'un appui (10) introduit dans le support (2) pendant la rotation (ω) du support (2).

10. Dispositif selon l'une quelconque des revendications précédentes, **caractérisé en ce que** deux moyeux opposés l'un à l'autre (13, 14), qui forment les deux extrémités de l'axe de rotation (23) de l'appui (10), sont installés sur le côté extérieur de l'appui (10).

11. Procédé pour retourner un objet (12) dans une installation de revêtement sous vide, comprenant les étapes de procédé suivantes :
- maintenir l'objet (12) avec un appui (10) pouvant tourner autour d'un axe de rotation (23) sur un support (2),
- retourner l'appui (10) maintenant l'objet (12) par la rotation autour de l'axe de rotation (23),
**caractérisé en ce que**
- on effectue la rotation de l'appui (10) autour de l'axe de rotation (23) avec une force produite par un générateur de force (2), qui est transmise sans pièces mécaniquement mobiles à l'appui (10), dans lequel la force comprend une force d'inertie, et que
- on déplace le support (2) de façon linéaire ou rotative pour retourner l'appui (10), sans que le support (2) lui-même soit retourné, dans lequel le mouvement linéaire ou le mouvement de rotation (ω) du support (2) est accéléré ou freiné de telle manière que l'appui (10) se retourne.

12. Procédé pour retourner un objet (12) dans une installation de revêtement sous vide, comprenant les étapes de procédé suivantes :
- maintenir l'objet (12) avec un appui (10) pouvant tourner autour d'un axe de rotation (23) sur un support (2),
- retourner l'appui (10) maintenant l'objet (12) par la rotation autour de l'axe de rotation (23),
**caractérisé en ce que**
- on effectue la rotation de l'appui (10) autour de l'axe de rotation (23) avec une force produite par un générateur de force (4, 22), qui est transmise sans pièces mécaniquement mobiles à l'appui (10), dans lequel la force comprend une force magnétique, et que
- on déplace le support (2) de façon linéaire ou rotative pour retourner l'appui (10), sans que le support (2) lui-même soit retourné, et l'appui (10) interagit avec la force magnétique, pendant le mouvement linéaire ou la rotation du support (2), de telle manière que l'appui (10) se retourne et/ou que le générateur de force (4, 22) est mobile linéairement ou en rotation par rapport à l'axe de rotation (23) de l'appui (10) pour le retournement de l'appui (10) et l'appui (10) est retourné par interaction magnétique.

13. Utilisation d'un dispositif selon l'une quelconque des revendications 1 à 10 ou d'un procédé selon l'une des revendications 11 ou 12 pour retourner des éléments optiques (12), en particulier des lentilles ophtalmiques (12), dans une installation de revêtement sous vide, avant leur revêtement et/ou pendant leur revêtement et/ou après leur revêtement.
